# EUROPÄISCHE PATENTANMELDUNG

(11) **EP 4 557 385 A1**
(43) Veröffentlichungstag der Anmeldung: **21.05.2025**
(21) Anmeldenummer: 23209808.7
(22) Anmeldetag: 14.11.2023
(51) Int. Cl.: H01L 31/054, H02S 20/30, H02S 40/22, H01L 31/042

(54) **NUTZFAHRZEUG MIT PHOTOVOLTAIKMODUL**

(71) Anmelder: Schmitz Cargobull AG, 48341 Altenberge (DE)
(72) Erfinder: MAIER, Christof, 41564 Kaarst (DE); KAUP, Carsten, 48653 Coesfeld (DE); LÜNENBORG, Stefan, 46325 Weseke (DE); BOCKHOLD, Julien, 60318 Frankfurt am Main (DE)
(74) Vertreter: Cohausz & Florack

(57) **Zusammenfassung**

Beschrieben und dargestellt ist ein Aufbau (5) eines Nutzfahrzeugs (1), insbesondere Lastkraftwagen, Anhänger oder Sattelauflieger, mit einem festen Dach (7) und wenigstens einem auf dem festen Dach (7) angeordneten Photovoltaikmodul (14), wobei das Photovoltaikmodul (14) eine Photovoltaiklage (22) umfassend Photovoltaikzellen (24) aufweist. Damit eine hohe Effizienz und Langlebigkeit der Photovoltaikmodule auch bei sehr stark schwankender Sonneneinstrahlung bereitgestellt werden kann, ist vorgesehen, dass das Photovoltaikmodul (14) eine Reflexionslage (25) zur Reflexion von wenigstens 20 % von auf die Reflexionslage (25) auftreffender Sonnenstrahlung in einem Wellenlängenbereich zwischen 400 nm und 780 nm vor der Photovoltaiklage (22) aufweist.

## Beschreibung

Die Erfindung betrifft einen Aufbau eines Nutzfahrzeugs, insbesondere Lastkraftwagen, Anhänger oder Sattelauflieger, mit einem festen Dach und wenigstens einem auf dem festen Dach angeordneten Photovoltaikmodul, wobei das Photovoltaikmodul eine Photovoltaiklage umfassend Photovoltaikzellen aufweist. Ferner betrifft die Erfindung ein Nutzfahrzeug mit einem solchen Aufbau.

Nutzfahrzeuge, beispielsweise in Form von Lastkraftwagen, Anhängern und Sattelaufliegern, sind insbesondere für den Transport von Gütern, vorzugsweise Stückgütern, im öffentlichen Straßenverkehr vorgesehen. Zu diesem Zweck weisen die Nutzfahrzeuge unterschiedliche Arten von Aufbauten auf, welche der Aufnahme der zu transportierenden Güter in einem Laderaum dienen.

So sind beispielsweise Planenaufbauten bekannt, bei denen die Seitenwände und das Dach durch wenigstens eine Planeneinheit verschlossen sind. Die Stirnwand ist bei Planenaufbauten meist als feste Wand ausgebildet, während die Rückwand regelmäßig durch zwei Flügeltüren gebildet wird, um den Laderaum bedarfsweise von hinten zu beladen. Wenn eine Planeneinheit entlang der Seitenwand verschoben werden kann, spricht man auch von sogenannten Curtainsidern. Das Dach von Planenaufbauten weist typischerweise seitlich angeordnete Holmstrukturen in Form von Längsholmen auf, die unter Bildung einer Rahmenstruktur quer zum Nutzfahrzeug über Spriegel miteinander verbunden sind. Die Rahmenstruktur trägt dann die das Dach verschließende Planeneinheit, wobei die Rahmenstruktur durch Rungen getragen wird, die sich wenigstens an den Ecken des Nutzfahrzeugs befinden.

Neben den Planenaufbauten sind beispielsweise auch Kofferaufbauten mit festen Seitenwänden, einer festen Stirnwand und einem festen Dach bekannt, welche den Laderaum umschließen. Da die Kofferaufbauten geschlossen sind, sind Kofferaufbauten in besonderem Maße für den Transport von feuchtigkeitsempfindlichen und/oder temperaturempfindlichen Gütern, also beispielsweise für den sogenannten Trockentransport und/oder den Kühltransport, geeignet. Die Rückwand der Kofferaufbauten wird meist durch zwei Flügeltüren oder ein Rolltor verschlossen.

Die Kofferaufbauten weisen oftmals an der Stirnwand, dem Dach und/oder den Seitenwänden zweischalige Paneele auf. Die Paneele umfassen dabei eine äußere und eine innere, strukturgebende Decklage sowie eine dazwischen vorgesehene Kernlage, die typischerweise aus einem geschäumten Kunststoff gebildet wird. Dabei können die innere und/oder die äußere Decklage selbst bedarfsweise mehrlagig aufgebaut sein.

Darüber hinaus sind Kofferaufbauten mit einschaligen Paneelen bekannt, die einen umlaufenden Rahmen oder eine von dem Paneel verschlossene Gitterstruktur aus vertikalen und horizontalen Profilen aufweisen. Das Paneel wird dabei meist aus einem oder aus mehreren Paneelelementen gebildet, die wenigstens im Wesentlichen aus einem glasfaserverstärkten Kunststoff, Stahl oder Aluminium gebildet sind, sowie bedarfsweise lackiert sind. Nutzfahrzeuge mit entsprechenden Aufbauten werden teilweise auch als sogenannte Trockenfrachter bezeichnet.

Aufbauten von Nutzfahrzeugen mit einem festen Dach bieten sich für die Montage eines Photovoltaikmoduls auf dem Dach an. Das Photovoltaikmodul ist auf dem Dach zeitweise einer nicht unerheblichen Sonneneinstrahlung ausgesetzt, die genutzt werden kann, um elektrische Verbraucher mit Strom zu versorgen. Dies kann direkt erfolgen, wobei es grundsätzlich bevorzugt sein wird, den mittels des Photovoltaikmoduls erzeugten Strom zunächst in einer Batterie zu speichern. Dann kann die Batterie je nach Bedarf zur Spannungsversorgung des entsprechenden Verbrauchers genutzt werden. Die Batterie ist dabei in einigen Fällen ebenfalls Teil des Nutzfahrzeugs.

Photovoltaikmodule auf Dächern von Nutzfahrzeugen können sehr unterschiedlich intensiver Sonneneinstrahlung ausgesetzt sein. Die Photovoltaikmodule sind dabei nicht nur Schwankungen der Sonneneinstrahlung über den Tag-Nacht-Zyklus und über die verschiedenen Jahreszeiten ausgesetzt. Die Sonneneinstrahlung kann auch dadurch stark variieren, dass das Nutzfahrzeug regelmäßig seinen Aufenthaltsort wechselt. Gleichzeitig wird eine hohe Effizienz und Langlebigkeit der Photovoltaikmodule angestrebt, die auch aufgrund der stark schwankenden Sonneneinstrahlung noch nicht in zufriedenstellendem Maße erreicht wird.

Daher liegt der vorliegenden Erfindung die Aufgabe zugrunde, den Aufbau der eingangs genannten und zuvor näher beschriebenen Art derart auszugestalten und weiterzubilden, dass eine hohe Effizienz und Langlebigkeit der Photovoltaikmodule auch bei sehr stark schwankender Sonneneinstrahlung bereitgestellt werden kann.

Diese Aufgabe ist bei einem Aufbau nach dem Oberbegriff des Anspruchs 1 dadurch gelöst, dass das Photovoltaikmodul eine Reflexionslage zur Reflexion von wenigstens 20 % von auf die Reflexionslage auftreffender Sonnenstrahlung in einem Wellenlängenbereich zwischen 400 nm und 780 nm vor der Photovoltaiklage aufweist.

Die wenigstens teilweise Reflexion im Wellenlängenbereich des Lichts zwischen 400 nm und 780 nm reduziert die Erwärmung der Photovoltaikmodule bei starker Sonneneinstrahlung, was zu einer höheren Effizienz der Photovoltaikmodule führt. Licht im Wellenlängenbereich zwischen 400 nm und 780 nm wird von Photovoltaikmodulen oftmals nicht oder nur zu einem geringeren Teil in Strom umgewandelt. Hierzu dient insbesondere Infrarotstrahlung (IR-Strahliung) einer höheren Wellenlänge. Typische Photovoltaikmodule nutzen zur Stromerzeugung insbesondere Sonnenlicht in einem Wellenlängenbereich zwischen 800 nm und 1200 nm.

Die reduzierten Temperaturen im Vergleich zu gewöhnlichen Photovoltaikmodulen, die aufgrund ihrer sehr dunklen Farbgebung das einfallende Sonnenlicht in sehr hohem Maße absorbieren, führt zudem zu einer Schonung des Dachs des Aufbaus des Nutzfahrzeugs. Durch die geringeren Temperaturen wird insbesondere ein teilweises Delaminieren einzelner Schichten des Dachs verhindert, wobei insbesondere solche Schichten des Dachs einer hohen Gefahr des Delaminierens ausgesetzt sind, die nahe der Oberseite des Dachs und damit nahe des Photovoltaikmoduls angeordnet sind. Erhöhte Temperaturen können die Haftung einzelner Schichten aneinander beeinträchtigen, insbesondere verwendete Klebstoffschichten schwächen. Dies kann dazu führen, dass sich einzelne Schichten des Dachs wenigstens bereichsweise voneinander lösen. Wenn die Schichten bereichsweise nicht mehr miteinander verbunden sind, kann dies zu einem unerwünschten Eintrag von Feuchtigkeit oder zu einer verringerten Steifigkeit des Dachs führen. Erhöhte Temperaturen können auch dazu führen, dass sich die Verklebung zwischen dem Dach und dem Photovoltaikmodul teilweise löst. Dies kann zur Folge haben, dass das Photovoltaikmodul während der Fahrt verloren geht.

Bei einer ersten besonders bevorzugten Ausgestaltung des Aufbaus ist vorgesehen, dass die Reflexionslage wenigstens 30 %, vorzugsweise wenigstens 40 %, insbesondere wenigstens 50 % von auf die Reflexionslage auftreffender Sonnenstrahlung im Wellenlängenbereich zwischen 400 nm und 780 nm reflektiert. Je mehr der auf die Photovoltaikmodule auftreffenden Sonnenstrahlung im Wellenlängenbereich zwischen 400 nm und 780 nm reflektiert wird, um so kühler bleiben die Photovoltaikmodule. Gleichfalls werden die Photovoltaikmodule, insbesondere bei starker Sonneneinstrahlung, effizienter und wird das Dach bzw. die Verbindung zwischen Dach und Photovoltaikmodul geschont.

Der Einfachheit halber bietet es sich im Übrigen an, wenn die Reflexionslage, insbesondere an ihrer Rückseite, eine Mikrostrukturierung zur Reflexion von Sonnenstrahlung in einem Wellenlängenbereich zwischen 400 nm und 780 nm aufweist. Eine solche Mikrostrukturierung lässt sich einfach vorsehen, wobei die Mikrostrukturierung gegenüber äußeren Einflüssen geschützt ist, wenn sie an der Rückseite der Reflexionslage vorgesehen ist. Besonders zweckmäßig sind in diesem Zusammenhang Mikrostrukturierungen mit einer Tiefe zwischen 10 nm und 10 µm, vorzugsweise zwischen 100 nm und 5 µm, insbesondere zwischen 200 nm und 2 µm, aufweist.

Alternativ oder zusätzlich kann es sich auch anbieten, wenn in der Reflexionslage Nanopartikel fein verteilt angeordnet sind, welche die Sonnenstrahlung in einem Wellenlängenbereich zwischen 400 nm und 780 nm reflektieren. Solche Nanopartikel weisen dabei vorzugsweise eine Größe zwischen 10 nm und 500 nm, insbesondere eine Größe zwischen 50 nm und 250 nm auf. Alternativ oder zusätzlich können die Nanopartikel aus einem Metalloxid, insbesondere Titandioxid (TiO₂), Zinkoxid (ZnO) oder Zirkoniumdioxid (ZrOz), gebildet sein. In einer einfachen und zugleich funktionalen Ausgestaltung sind in der Reflexionslage Nanopartikel fein verteilt angeordnet.

Denkbar ist dagegen auch oder in Ergänzung dazu, dass die Reflexionslage eingefärbt ist. Anders als die sehr dunklen Photovoltaikmodule wird bei eingefärbten Reflexionslagen ein größerer Teil des sichtbaren Lichts reflektiert. Wie hoch dieser Anteil ist und in welchem Wellenlängenbereich Licht reflektiert wird, hängt dabei stark von der Farbgebung der Reflexionslage ab. Aus diesen Gründen kann es zweckmäßig sein, wenn die Farbpigmente weiß sind. In einer einfachen und zugleich funktionalen Ausgestaltung sind in der Reflexionslage Farbpigmente fein verteilt angeordnet. Bei den Farbpigmenten kann es sich um Nanopartikel handeln, und zwar bedarfsweise auch um die vorstehend genannten Nanopartikel.

Zur Bereitstellung einer hohen Effizienz der Photovoltaikmodule bietet es sich ferner an, wenn die Reflexionslage wenigstens 70 %, vorzugsweise wenigstens 80 %, insbesondere wenigstens 90 %, der auftreffenden Sonnenstrahlung in einem Wellenlängenbereich zwischen 800 nm bis 1200 nm transmittiert. Für diesen Anteil der Sonnenstrahlung dieses Wellenlängenbereichs ist die Reflexionslage mithin transparent, so dass der durch die Reflexionslage durchdringende Teil des Sonnenlichts von den Photovoltaikmodulen in Strom umgewandelt werden kann.

Die beschriebene Reflexionslage ist besonders zweckdienlich, wenn es sich bei den Photovoltaikzellen der Photovoltaiklage um CIGS-Solarzellen oder kristalline Silizium-Solarzellen handelt. Bei CIGS-Solarzellen ist der Absorber aus Kupfer-Indium-Gallium-Diselenid (CIGS) gebildet. CIGS-Solarzellen besitzen anders als kristalline Silizium-Solarzellen einen Absorber mit einer direkten Bandlücke, so dass ein höherer Absorptionskoeffizient erreicht wird. Licht wird folglich in höherem Maße absorbiert. Besonders zweckmäßig für funktionale und langlebige Photovoltaikmodule kann es sein, wenn die Photovoltaikzellen beidseitig in einer Kunststofflage aufgenommen sind. Die Photovoltaiklage kann entsprechend durch die Photovoltaikzellen und die diese aufnehmende Kunststoffschicht bzw. den entsprechenden Kunstsoff gebildet sein.

Alternativ oder zusätzlich kann die Reflexionslage ihre Funktion effektiv erfüllen, wenn die Reflexionslage zwischen der Photovoltaiklage und einer Deckschicht angeordnet ist. Die Deckschicht schließt das Photovoltaikmodul nach außen ab und dient folglich dem Schutz des Photovoltaikmoduls vor schädlichen äußeren Einflüssen. Ein einfacher und zugleich wirkungsvoller Aufbau kann erreicht werden, wenn die Reflexionslage zwischen der Decklage und der Photovoltaiklage angeordnet ist.

Zum Schutz der Photovoltaikzellen ebenso wie des Dachs bietet es sich an, wenn zwischen dem festen Dach und der Photovoltaiklage eine Substratschicht vorgesehen ist. Die Substratschicht verleiht dem Photovoltaikmodul ein Teil seiner Steifigkeit und sorgt zugleich für eine gewisse räumliche Distanz zwischen dem Dach und den Photovoltaikzellen. Dabei ist die Substratschicht insbesondere zwischen dem Dach und der Photovoltaiklage angeordnet. Die Substratschicht kann der Einfachheit halber auf dem festen Dach verklebt sein.

Unabhängig davon ist es in vielen Fällen zweckmäßig, wenn die Deckschicht und/oder die Substratschicht aus Glas gebildet werden. Glas ist sehr steif und zugleich sehr widerstandsfähig gegenüber äußeren Einflüssen. Glas weist auch eine hohe Transparenz für Sonnenstrahlung in einem Wellenlängenbereich zwischen 800 nm und 1200 nm auf.

Die beschriebenen Vorteile kommen insbesondere bei einem Dach eines Aufbaus zum Tragen, der als ein Paneelaufbau mit zwei äußeren strukturgebenden Decklagen und einer zwischen den Decklagen angeordneten Kernlage aus einem, vorzugsweise geschäumten, Kunststoff ausgebildet ist. Solche Dachpaneele können durch übermäßige Hitzeeinwirkung leicht beschädigt werden, und zwar umso eher, je stärker die Kernlage thermisch isolierend wird. Die durch die Sonneneinstrahlung im Photovoltaikmodul erzeugte Wärme kann dann nur schlecht abgeleitet werden, was eine lokale Überhitzung des Dachs zur Folge haben kann. Zudem kann es sich anbieten, wenn die strukturgebenden Decklagen jeweils wenigstens eine Schicht aus Metall, insbesondere Aluminium oder Stahl, und/oder eine Schicht aus einem faserverstärkten Kunststoff aufweisen. Solche Schichten sind verhältnismäßig widerstandsfähig gegenüber erhöhten Temperaturen und stellen ein hohes Maß an Steifigkeit bereit.

Die beschriebenen Vorteile kommen im Falle eines Aufbaus in Form eines Kofferaufbaus mit festen Seitenwänden, einer festen Stirnwand und einer Rückwand besonders zum Tragen. Solche Kofferaufbauten können zweckmäßig mit Photovoltaikmodulen ausgestattet werden, etwa zum Betrieb einer Transportkältemaschine. Bei einem Kofferaufbau können die Seitenwände einen Paneelaufbau mit jeweils zwei äußeren strukturgebenden Decklagen und einer zwischen den Decklagen angeordneten Kernlage aus einem, vorzugsweise geschäumten, Kunststoff aufweisen, so dass der Kofferaufbau eine hohe thermische Isolation bereitstellt und sind demnach gut für Kühltransporte eignet. Zur Kühlung kann dann eine Transportkältemaschine vorgesehen sein, die sich unter Verwendung der mittels des Photovoltaikmoduls erzeugten Stroms betreiben lässt. Weiter bevorzugt ist es, wenn die strukturgebenden Decklagen der Seitenwände jeweils wenigstens eine Schicht aus Metall, insbesondere Aluminium oder Stahl, und/oder eine Schicht aus einem faserverstärkten Kunststoff aufweisen. Solche Schichten sind verhältnismäßig widerstandsfähig und stellen ein hohes Maß an Steifigkeit bereit.

Bei einer ersten besonders bevorzugten Ausgestaltung des Nutzfahrzeugs ist eine über das Photovoltaikmodul zu ladende Batterie vorgesehen. Die Batterie kann den Strom von dem Photovoltaikmodul speichern, bis dieser zum Betrieb eines Verbrauchers benötigt wird. Vor diesem Hintergrund kann es sich besonders anbieten, wenn das Nutzfahrzeug eine von der Batterie mit Strom zu versorgende Transportkältemaschine zur Kühlung eines Laderaums des Nutzfahrzeugs aufweist.

Nachfolgend wird die Erfindung anhand einer lediglich ein Ausführungsbeispiel darstellenden Zeichnung näher erläutert. Die Zeichnung zeigt
- Fig. 1: ein von einer Zugmaschine gezogenes erfindungsgemäßes Nutzfahrzeug mit einem erfindungsgemäßen Aufbau in einer perspektivischen Ansicht und
- Fig. 2: das Dach des Aufbaus aus der Fig. 1 im Bereich des Photovoltaikmoduls in einer Schnittansicht entlang einer Schnittebene quer zum Dach.

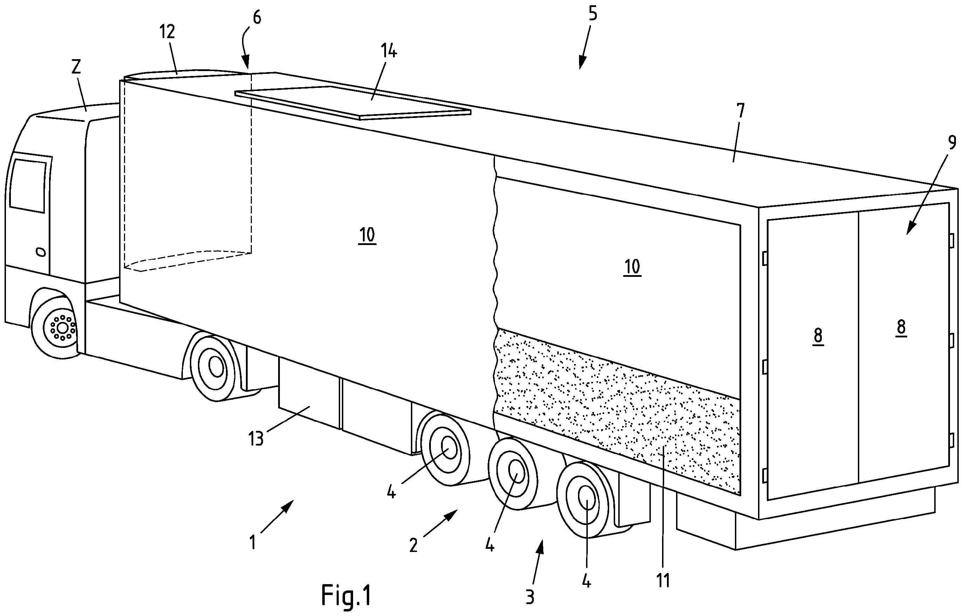

In der Fig. 1 ist ein von einer Zugmaschine Z gezogenes Nutzfahrzeug 1 in Form eines Sattelaufliegers dargestellt. Das Nutzfahrzeug 1 umfasst ein Chassis 2 und ein daran befestigtes Fahrwerk 3 umfassend drei separate Achsen 4. Von dem Chassis 2 wird zudem ein Aufbau 5 in Form eines Kofferaufbaus mit einer festen Stirnwand 6, einem festen Dach 7, festen Rückwandtüren 8 an einer Rückwand 9 und festen Seitenwänden 10 getragen. Die Stirnwand 6, die Seitenwände 10 und das Dach 7 werden durch Paneele gebildet, welche eine äußere Decklage und eine innere Decklage aufweisen, zwischen denen eine Kernlage aus einem geschäumten Kunststoff vorgesehen ist. Bei der inneren Decklage und der äußeren Decklage handelt es sich um strukturgebende Decklagen, die auch jeweils mehrlagig ausgebildet sein können. Die vorliegenden Decklagen umfassen eine Schicht aus Aluminium. Die Kernlage dient dabei primär der thermischen Isolierung eines im Aufbau 5 vorgesehenen Laderaums 11.

An der Stirnwand 6 ist eine Transportkältemaschine 12 vorgesehen, die Luft aus dem Laderaum 11 des Aufbaus 5 ansaugt, kühlt und wieder in den Laderaum 11 zurück bläst. Die Transportkältemaschine 12 kann elektrisch angetrieben werden. Zur Spannungsversorgung der Transportkältemaschine 12 ist unterhalb des Aufbaus 5 im Bereich des Chassis 2 eine Batterie 13 vorgesehen, die über ein auf dem Dach 7 des Aufbaus 5 montiertes Photovoltaikmodul 14 geladen werden kann. Das Photovoltaikmodul 14 ist dabei über elektrische Kabel und eine Steuereinrichtung mit der Batterie 13 verbunden, was ebenso wenig dargestellt ist, wie der Umstand, dass die Batterie 13 über elektrische Kabel mit der Transportkältemaschine 12 verbunden ist.

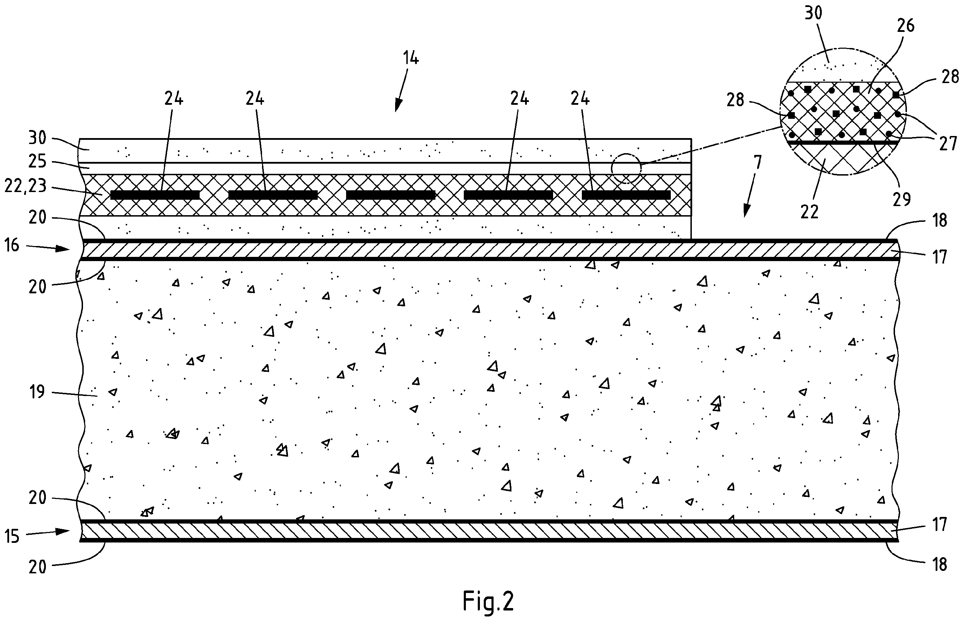

In der Fig. 2 ist ein Schnitt durch das Dach 7 im Bereich des Photovoltaikmoduls 14 dargestellt. Die einzelnen Schichten des Dachs 7 und des Photovoltaikmoduls 14 sind der besseren Anschaulichkeit halber nicht maßstabsgerecht dargestellt. Das feste Dach 7 wird durch ein Paneel mit einer dem Laderaum 11 zugewandten Decklage 15 und eine dem Photovoltaikmodul 14 zugewandten Decklage 16 gebildet. Beide Decklagen 15,16 weisen eine Aluminiumschicht 17 auf, die auf der Außenseite eine Lackschicht 18 trägt. Auf der Innenseite sind die Aluminiumschichten 17 mit der dazwischen vorgesehenen Kernlage 19 aus einem geschäumten Kunststoff verklebt. Sowohl zwischen der Aluminiumschicht 17 und der Kernlage 19 als auch zwischen der Aluminiumschicht 17 und der Lackschicht 18 ist ein Haftvermittler 20 vorgesehen, welche die dauerhafte und zuverlässige Verbindung der Schichten untereinander sicherstellt. Auf dem Dach 7 ist ein Photovoltaikmodul 14 vorgesehen, das mit einer rückseitigen Substratschicht 21 aus Glas mit dem Dach 7 verklebt ist. Auf die Substratschicht 21 ist eine Photovoltaiklage 22 aufgeklebt, die eine Kunststofflage 23 aufweist, in die einzelne Photovoltaikzellen 24 eingebettet sind. Der Kunststoff der Photovoltaiklage 22 umschließt die Photovoltaikzellen 24 zu allen Seiten.

Auf der Photovoltaiklage 22 ist eine Reflexionslage 25 vorgesehen, die vorliegend ebenfalls aus einem Kunststoff 26 gebildet ist. Der Kunststoff 26 weist dabei Nanopartikel 27 und Farbpigmente 28 auf. Die Nanopartikel 27 und Farbpigmente 28 sind dabei als disperse Phase in der kontinuierlichen Phase aus dem Kunststoff 26 der Reflexionslage 25 fein verteilt angeordnet. Bedarfsweise bilden die Nanopartikel 27 die Farbpigmente 28 oder umgekehrt. Die Nanopartikel 27 reflektieren einen Teil des auf das Photovoltaikmodul 14 einfallenden Lichts im Wellenlängenbereich zwischen 400 nm und 780 nm. Die Farbpigmente 28 reflektieren je nach Farbe ebenfalls einen Teil des auf das Photovoltaikmodul 14 einfallenden Lichts im Wellenlängenbereich zwischen 400 nm und 780 nm. An der Unterseite der Reflexionslage 25 ist ferner eine Mikrostrukturierung 29 mit einer Tiefe zwischen 10 nm und 10 µm, welche einen weiteren Teil des auf das Photovoltaikmodul 14 einfallenden Lichts im Wellenlängenbereich zwischen 400 nm und 780 nm reflektiert. Das Licht im Wellenlängenbereich zwischen 800 nm bis 1200 nm wird überwiegend transmittiert. Die Photovoltaikzellen 24 wandeln insbesondere das einfallende Sonnenlicht im Wellenlängenbereich zwischen 800 nm bis 1200 nm in elektrischen Strom um. Die Photovoltaikzellen 24 sind dabei als CIGS-Solarzellen ausgebildet. Auf der Reflexionslage 25 ist eine Deckschicht 30 aus Glas vorgesehen, die das Photovoltaikmodul 14 nach oben abschließt und gegenüber Beschädigungen und dergleichen schützt. Die obere Deckschicht 30 ist dabei mit der Reflexionslage 25 verklebt.

### Bezugszeichenliste

- 1: Nutzfahrzeug
- 2: Chassis
- 3: Fahrwerk
- 4: Achse
- 5: Aufbau
- 6: Stirnwand
- 7: Dach
- 8: Rückwandtür
- 9: Rückwand
- 10: Seitenwand
- 11: Laderaum
- 12: Transportkältemaschine
- 13: Batterie
- 14: Photovoltaikmodul
- 15: Decklage
- 16: Decklage
- 17: Aluminiumschicht
- 18: Lackschicht
- 19: Kernlage
- 20: Haftvermittler
- 21: Substratschicht
- 22: Photovoltaiklage
- 23: Kunststofflage
- 24: Photovoltaikzelle
- 25: Reflexionslage
- 26: Kunststoff
- 27: Nanopartikel
- 28: Farbpigment
- 29: Mikrostrukturierung
- 30: Deckschicht
- Z: Zugmaschine

## Patentansprüche

1. Aufbau (5) eines Nutzfahrzeugs (1), insbesondere Lastkraftwagen, Anhänger oder Sattelauflieger, mit einem festen Dach (7) und wenigstens einem auf dem festen Dach (7) angeordneten Photovoltaikmodul (14), wobei das Photovoltaikmodul (14) eine Photovoltaiklage (22) umfassend Photovoltaikzellen (24) aufweist,
**dadurch gekennzeichnet, dass**
das Photovoltaikmodul (14) eine Reflexionslage (25) zur Reflexion von wenigstens 20 % von auf die Reflexionslage (25) auftreffender Sonnenstrahlung in einem Wellenlängenbereich zwischen 400 nm und 780 nm vor der Photovoltaiklage (22) aufweist.

2. Aufbau nach Anspruch 1,
**dadurch gekennzeichnet, dass**
die Reflexionslage (25) wenigstens 30 %, vorzugsweise wenigstens 40 %, insbesondere wenigstens 50 % von auf die Reflexionslage (25) auftreffender Sonnenstrahlung in einem Wellenlängenbereich zwischen 400 nm und 780 nm reflektiert.

3. Aufbau nach Anspruch 1 oder 2,
**dadurch gekennzeichnet, dass**
die Reflexionslage (25), insbesondere an ihrer Rückseite, eine Mikrostrukturierung (29) zur Reflexion von Sonnenstrahlung in einem Wellenlängenbereich zwischen 400 nm und 780 nm aufweist und dass, vorzugsweise, die Mikrostrukturierung (29) eine Tiefe zwischen 10 nm und 10 µm, vorzugsweise zwischen 100 und 5 µm, insbesondere zwischen 200 nm und 2 µm, aufweist.

4. Aufbau nach einem der Ansprüche 1 bis 3,
**dadurch gekennzeichnet, dass**
in der Reflexionslage (25) Sonnenstrahlung in einem Wellenlängenbereich zwischen 400 nm und 780 nm reflektierende Nanopartikel (27) fein verteilt angeordnet sind.

5. Aufbau nach einem der Ansprüche 1 bis 4,
**dadurch gekennzeichnet, dass**
die Reflexionslage (25) eingefärbt ist und dass, vorzugsweise, in der Reflexionslage (25) Farbpigmente (28) fein verteilt angeordnet sind.

6. Aufbau nach einem der Ansprüche 1 bis 5,
**dadurch gekennzeichnet, dass**
auf die Reflexionslage (25) von wenigstens 70 %, vorzugsweise wenigstens 80 %, insbesondere wenigstens 90 %, der auftreffenden Sonnenstrahlung in einem Wellenlängenbereich zwischen 800 nm bis 1200 nm transmittiert wird.

7. Aufbau nach einem der Ansprüche 1 bis 6,
**dadurch gekennzeichnet, dass**
die Photovoltaikzellen (24) CIGS-Solarzellen oder kristalline Silizium-Solarzellen sind und dass, vorzugsweise, die Photovoltaikzellen (24) beidseitig in einer Kunststofflage (23) der Photovoltaiklage (22) aufgenommen sind.

8. Aufbau nach einem der Ansprüche 1 bis 7,
**dadurch gekennzeichnet, dass**
die Reflexionslage (25) zwischen den Photovoltaikzellen (24), insbesondere der Photovoltaiklage (22), und einer Deckschicht (30) angeordnet ist.

9. Aufbau nach einem der Ansprüche 1 bis 8,
**dadurch gekennzeichnet, dass**
zwischen dem festen Dach (7) und den Photovoltaikzellen (24), insbesondere der Photovoltaiklage (22), eine Substratschicht (21) vorgesehen ist und dass, vorzugsweise, die Substratschicht (21) auf dem festen Dach (7) verklebt ist.

10. Aufbau nach Anspruch 8 oder 9,
**dadurch gekennzeichnet, dass**
die Deckschicht (30) und/oder die Substratschicht (21) aus Glas gebildet werden.

11. Aufbau nach einem der Ansprüche 1 bis 10,
**dadurch gekennzeichnet, dass**
das Dach (7) des Aufbaus (5) einen Paneelaufbau mit zwei äußeren strukturgebenden Decklagen (15,16) und einer zwischen den Decklagen (15,16) angeordneten Kernlage (19) aus einem, vorzugsweise geschäumten, Kunststoff ist, und wobei die strukturgebenden Decklagen (15,16) jeweils wenigstens eine Schicht aus Metall, insbesondere Aluminium (17) oder Stahl, und/oder eine Schicht aus einem faserverstärkten Kunststoff aufweisen.

12. Aufbau nach einem der Ansprüche 1 bis 11,
**dadurch gekennzeichnet, dass**
der Aufbau (5) ein Kofferaufbau mit festen Seitenwänden (10) und einer festen Stirnwand (6) ist und dass, vorzugsweise, die Seitenwände (10) des Aufbaus einen Paneelaufbau mit jeweils zwei äußeren strukturgebenden Decklagen (15,16) und einer zwischen den Decklagen (15,16) angeordneten Kernlage (19) aus einem, vorzugsweise geschäumten, Kunststoff bilden und dass, weiter vorzugsweise, die strukturgebenden Decklagen (15,16) der Seitenwände (10) jeweils wenigstens eine Schicht aus Metall, insbesondere Aluminium (17) oder Stahl, und/oder eine Schicht aus einem faserverstärkten Kunststoff aufweisen.

13. Nutzfahrzeug (1), insbesondere Lastkraftwagen, Anhänger oder Sattelauflieger, mit einem Aufbau (5) nach einem der Ansprüche 1 bis 12.

14. Nutzfahrzeug nach Anspruch 13,
**dadurch gekennzeichnet, dass**
das Nutzfahrzeug (1) eine über das Photovoltaikmodul (14) zu ladende Batterie (13) aufweist und dass, vorzugsweise, das Nutzfahrzeug (1) eine von der Batterie (13) mit Strom zu versorgende Transportkältemaschine (12) zur Kühlung eines Laderaums (11) des Nutzfahrzeugs (1) aufweist.
